# FASCICULE DE BREVET EUROPEEN

(11) **EP 3 070 744 B1**
(45) Date de publication et mention de la délivrance du brevet: **05.07.2017**
(21) Numéro de dépôt: 16160138.0
(22) Date de dépôt: 14.03.2016
(51) Int. Cl.: H01L 29/775, H01L 29/786, H01L 29/66, H01L 21/324, H01L 29/423, H01L 29/06, H01L 21/02, H01L 21/266, B82Y 10/00

(54) **PROCÉDÉ DE RÉALISATION AMELIORÉ D'UN TRANSISTOR DANS UN EMPILEMENT DE COUCHES SEMI-CONDUCTRICES SUPERPOSÉES**
VERBESSERTES HERSTELLUNGSVERFAHREN EINES TRANSISTORS IN EINEM STAPEL VON ÜBEREINANDER ANGEORDNETEN HALBLEITERSCHICHTEN
IMPROVED METHOD FOR PRODUCING A TRANSISTOR IN A STACK OF SUPERPOSED SEMICONDUCTOR LAYERS

(30) Priorité: 16.03.2015 FR 1552111
(43) Date de publication de la demande: 21.09.2016
(73) Titulaire: Commissariat à l'Energie Atomique et aux Energies Alternatives, 75015 Paris (FR)
(72) Inventeur: BARRAUD, Sylvain, 38690 LE GRAND LEMPS (FR); REBOH, Shay, 38054 Grenoble (FR); VINET, Maud, 38640 CLAIX (FR)
(74) Mandataire: Brevalex

(56) Documents cités:
- WO-A1-2006/038164
- WO-A1-2009/098548
- FR-A1- 2 995 134
- GODBEY D J ET AL: "SELECTIVE REMOVAL OF SI1-XGEX FROM (100) SI USING HNO3 AND HF", JOURNAL OF THE ELECTROCHEMICAL SOCIETY, ELECTROCHEMICAL SOCIETY, vol. 139, no. 10, 1 octobre 1992 (1992-10-01), pages 2943-2947, XP000359007, ISSN: 0013-4651
- M. VOS ET AL: "Selective amorphization of ion-bombarded SiGe strained-layer superlattices", APPLIED PHYSICS LETTERS, vol. 58, no. 9, 4 mars 1991 (1991-03-04), page 951, XP055239869, 2 Huntington Quadrangle, Melville, NY 11747 ISSN: 0003-6951, DOI: 10.1063/1.104488

## Description

### DOMAINE TECHNIQUE

La présente invention se rapporte au domaine de la micro-électronique et plus particulièrement à celui des transistors, et concerne la réalisation d'un transistor formé dans un empilement de couches semi-conductrices superposées.

Elle s'applique à la réalisation d'un transistor doté d'une région semi-conductrice de canal comportant une pluralité d'éléments semi-conducteurs répartis sur plusieurs niveaux, ces éléments semi-conducteurs pouvant être sous forme de nano-fils, ou de barreaux, ou de membranes.

Elle permet plus particulièrement une mise en oeuvre améliorée d'un transistor doté d'une telle région de canal et d'une grille enrobante disposée autour des éléments semi-conducteurs.

### ART ANTÉRIEUR

La réalisation d'un transistor dont la structure de canal est formée d'une pluralité de nano-fils répartis sur plusieurs niveaux est connue, comme montré par exemple par le document WO 2009/098548 A1. Un procédé de fabrication d'un tel transistor peut comprendre la formation d'un empilement de couches semi-conductrices comprenant une alternance de couche à base de Si et de couches à base de SiGe.

Puis, on effectue notamment un retrait sélectif du SiGe par rapport au Si, de manière à libérer les nano-fils de Si avant de déposer la grille du transistor.

Avec un tel procédé, pour permettre de libérer les nano-fils de Si tout en assurant un maintien de la structure, des règles de dessin contraignantes doivent généralement être appliquées.

Du fait de ces règles de dessin, l'encombrement de blocs de source et de drain est important et ne permet pas la mise en oeuvre d'une densité importante de nano-fils. Par ailleurs, un bon positionnement ainsi qu'une bonne définition du motif de grille s'avère difficile à obtenir.

Une autre méthode de réalisation d'un transistor à nano-fils consiste à former la grille par un procédé de type damascène.

Lors d'un tel procédé, on remplit une cavité 2 de matériau de grille après avoir effectué une étape de libération de nano-fils, par exemple en gravant sélectivement des nano-fils de SiGe par rapport à des nano-fils 4 de Si.

Un inconvénient d'une telle approche est qu'il est difficile d'éviter une sur-gravure du SiGe qui peut avoir tendance à atteindre des régions 6 dans lesquelles la source et le drain du transistor sont prévues.

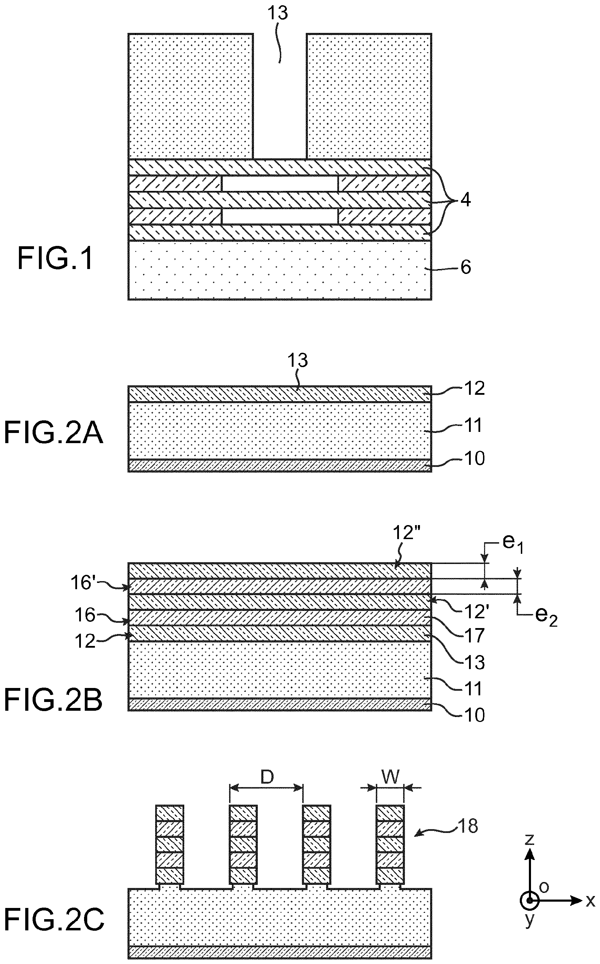

Un tel exemple de sur-gravure est illustré sur la figure 1. Cette sur-gravure peut avoir pour conséquence un agencement imprécis et non-uniforme de la grille que l'on vient ensuite réaliser dans la cavité 2. Cela peut engendrer notamment une augmentation des capacités parasites.

Plus généralement, il se pose le problème de trouver un nouveau procédé de réalisation d'un transistor formé dans un empilement de couches semi-conductrices superposées.

### EXPOSÉ DE L'INVENTION

L'invention prévoit un procédé de réalisation d'un transistor formé dans un empilement de couches semi-conductrices superposées, le procédé comprenant des étapes consistant à :
a) prévoir sur un substrat, au moins une structure semi-conductrice formée d'un empilement comprenant une alternance de couche(s) à base d'au moins un premier matériau semi-conducteur et de couche(s) à base d'au moins un deuxième matériau semi-conducteur différent du premier matériau semi-conducteur,
b) rendre amorphe à l'aide d'une ou plusieurs implantations d'ions, au moins une zone de la structure, la zone rendue amorphe comprenant une ou plusieurs portions d'une ou plusieurs couches à base du deuxième matériau semi-conducteur,
c) retirer les portions à base du deuxième matériau semi-conducteur rendu amorphe par gravure sélective du deuxième matériau semi-conducteur sous forme amorphe vis-à-vis du premier matériau semi-conducteur.

Un premier mode de réalisation prévoit que la zone rendue amorphe à l'étape b) est située dans une région centrale de la structure dans laquelle une région de canal du transistor est apte à être formée.

Dans ce cas, le procédé peut comprendre en outre, après l'étape a) et préalablement à l'étape b), la formation d'un masquage sur l'empilement, le masquage comprenant une ouverture dévoilant une région centrale de la structure, la ou les implantations d'amorphisation étant ensuite réalisées à travers l'ouverture du masquage, de sorte que la zone rendue amorphe est située dans l'ouverture tandis que l'on conserve la structure cristalline de parties de la ou des couches à base du deuxième matériau semi-conducteur qui sont protégées par le masquage et sont situées hors de l'ouverture.

Le retrait des portions peut être alors ensuite effectué à l'étape c) par gravure sélective du deuxième matériau semi-conducteur sous forme amorphe vis-à-vis des couches à base du premier matériau semi-conducteur et des parties de la ou des couches à base du deuxième matériau semi-conducteur dont la structure cristalline a été conservée à l'étape b).

Une telle gravure sélective peut permettre d'éviter de réaliser une sur-gravure intempestive de la structure.

Ensuite, on peut former une grille dans l'ouverture dans laquelle on a réalisé l'amorphisation.

Avantageusement, cette ouverture peut être une ouverture d'un masquage réalisé préalablement à l'étape b) par :
- formation d'une grille sacrificielle agencée sur la région centrale, puis
- formation d'une couche de masquage contre la grille sacrificielle de manière à former le masquage,
- formation de l'ouverture dans le masquage par retrait de la grille sacrificielle.

Un alignement précis de la grille peut être ainsi obtenu.

Selon une première possibilité de mise en oeuvre, l'amorphisation à l'étape b) peut être une amorphisation sélective des portions à base du deuxième matériau semi-conducteur vis-à-vis des couches à base du premier matériau semi-conducteur, et en particulier de portions des couches à base du premier matériau semi-conducteur qui sont situées dans l'ouverture.

Pour permettre une telle amorphisation sélective, on adapte les paramètres d'implantation et on choisit de manière adéquate le premier matériau semi-conducteur et le deuxième matériau semi-conducteur.

Le premier matériau semi-conducteur peut être en particulier à base de Si ou de Si₁₋ₓGeₓ (avec x > 0), tandis que le deuxième matériau semi-conducteur est à base de Si_{1-y}Ge_{y} avec x < y. La sélectivité d'amorphisation peut être adaptée en modulant la différence de concentration en Germanium entre le premier matériau semi-conducteur et le deuxième matériau semi-conducteur.

L'amorphisation sélective peut être réalisée par le biais de plusieurs implantations à des profondeurs différentes de la structure.

Selon une deuxième possibilité de mise en oeuvre, l'amorphisation à l'étape b) peut être une amorphisation partielle de la région centrale de la structure de sorte à rendre amorphe une ou plusieurs portions d'une ou plusieurs couches à base du deuxième matériau semi-conducteur ainsi qu'une ou plusieurs portions de couches données à base du premier matériau semi-conducteur qui se trouvent dans l'ouverture tout en conservant la structure cristalline d'au moins une couche à base du premier matériau semi-conducteur dévoilée également par l'ouverture.

Après retrait des portions du deuxième matériau semi-conducteur rendu amorphe à l'étape c), au moins une étape de recuit thermique de recristallisation peut être effectuée. On peut recristalliser ainsi les portions de couches données à base du premier matériau semi-conducteur.

Un deuxième mode de réalisation prévoit que la zone rendue amorphe à l'étape b) est située dans des régions de la structure dans lesquelles des régions de source et de drain du transistor sont aptes à être formées, la ou les implantations étant réalisées à l'étape b) de sorte à conserver la structure cristalline d'une région centrale de la structure dans laquelle une région de canal du transistor est apte à être réalisée.

Dans ce cas, un retrait des portions à base du deuxième matériau semi-conducteur sous forme amorphe est ensuite effectué par gravure sélective du deuxième matériau semi-conducteur sous forme amorphe vis-à-vis des couches à base du premier matériau semi-conducteur et de parties de la ou des couches à base de deuxième matériau semi-conducteur situées dans la région centrale et dont la structure cristalline a été conservée.

Le retrait des portions à base du deuxième matériau semi-conducteur sous forme amorphe peut conduire à la formation d'espaces vides.

Le procédé peut alors comprendre en outre des étapes de :
- dépôt d'un matériau donné dans les espaces vides, le matériau donné étant un matériau choisi de sorte que le deuxième matériau semi-conducteur sous forme amorphe est apte à être gravé de manière sélective vis-à-vis du matériau donné.
- formation d'un masquage doté d'une ouverture dévoilant la région centrale de la structure,
- retrait de parties à base du deuxième matériau semi-conducteur dans l'ouverture par gravure sélective du deuxième matériau semi-conducteur vis-à-vis du premier matériau semi-conducteur et du matériau donné.

Le matériau donné peut être avantageusement un matériau isolant.

Une telle gravure sélective peut permettre d'éviter de réaliser une sur-gravure intempestive de la structure.

A l'étape b), une grille sacrificielle peut être prévue sur la région centrale de la structure. Dans ce cas le procédé peut comprendre en outre la formation d'une couche de masquage contre la grille sacrificielle de manière à former un masquage, puis un retrait de la grille sacrificielle pour former une ouverture dans le masquage.

C'est ensuite à travers cette ouverture que l'on peut effectuer l'étape c) de retrait des parties à base du deuxième matériau semi-conducteur.

Une grille peut être ensuite déposée dans l'ouverture après l'étape c).

Le procédé peut comprendre en outre après l'étape c) au moins une étape de recuit thermique de sorte à re-cristallier les couches à base du premier matériau semi-conducteur.

Dans l'un ou l'autre des modes de réalisation, l'empilement réalisé peut comprendre une alternance de couche(s) à base de Si₁₋ₓGeₓ, et de couches à base de Si_{1-y}Ge_{y} avec 0 ≤ x < y.

Cet empilement peut avantageusement être formé sur un substrat de type SOI ou SiGeOI.

Selon un autre aspect, l'invention prévoit un procédé de réalisation d'un transistor formé dans un empilement de couches semi-conductrices superposées, le procédé comprenant des étapes consistant à :
- prévoir sur un substrat, au moins une structure semi-conductrice formée d'un empilement comprenant une alternance de couche(s) à base d'au moins un premier matériau semi-conducteur et de couche(s) à base d'au moins un deuxième matériau semi-conducteur différent du premier matériau semi-conducteur,
- retirer dans une région centrale de la structure dévoilée par une ouverture d'un masquage des portions à base du deuxième matériau semi-conducteur, le retrait étant effectué :
- par gravure sélective du deuxième matériau semi-conducteur rendu amorphe dans l'ouverture vis-à-vis du premier matériau semi-conducteur, ou bien
- par gravure sélective du deuxième matériau semi-conducteur vis-à-vis du premier matériau semi-conducteur et d'un matériau donné entourant le deuxième matériau hors de l'ouverture et formé préalablement.

Ce matériau donné peut être formé par amorphisation à l'aide d'une ou plusieurs implantations de zones de la structure disposées de part et d'autre de la région centrale, puis gravure dans ces zones du deuxième matériau semi-conducteur sous forme amorphe et remplacement du deuxième matériau semi-conducteur sous forme amorphe par un matériau donné.

Ce matériau donné est choisi de sorte à pouvoir résister à une gravure sélective du deuxième matériau semi-conducteur.

Le matériau donné est avantageusement un matériau isolant.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
La figure 1 illustre un problème de surgravure susceptible d'apparaitre lors d'un procédé de réalisation d'une structure de canal à nano-fils mis en oeuvre suivant l'art antérieur;
Les figures 2A-2O illustrent un premier exemple de procédé de réalisation d'un transistor suivant un mode de réalisation de la présente invention ;
Les figures 3A-3C illustrent un deuxième exemple de procédé de réalisation d'un transistor suivant un mode de réalisation de la présente invention ;
Les figures 4A-4H illustrent un troisième exemple de procédé de réalisation d'un transistor suivant un mode de réalisation de la présente invention ;

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme pour rendre les figures plus lisibles.

En outre, dans la description ci-après, des termes qui dépendent de l'orientation, telle que « sur », « au-dessus », « supérieure », « latérale » etc. d'une structure s'appliquent en considérant que la structure est orientée de la façon illustrée sur les figures.

### EXPOSÉ DÉTAILLÉ DE MODES DE RÉALISATION PARTICULIERS

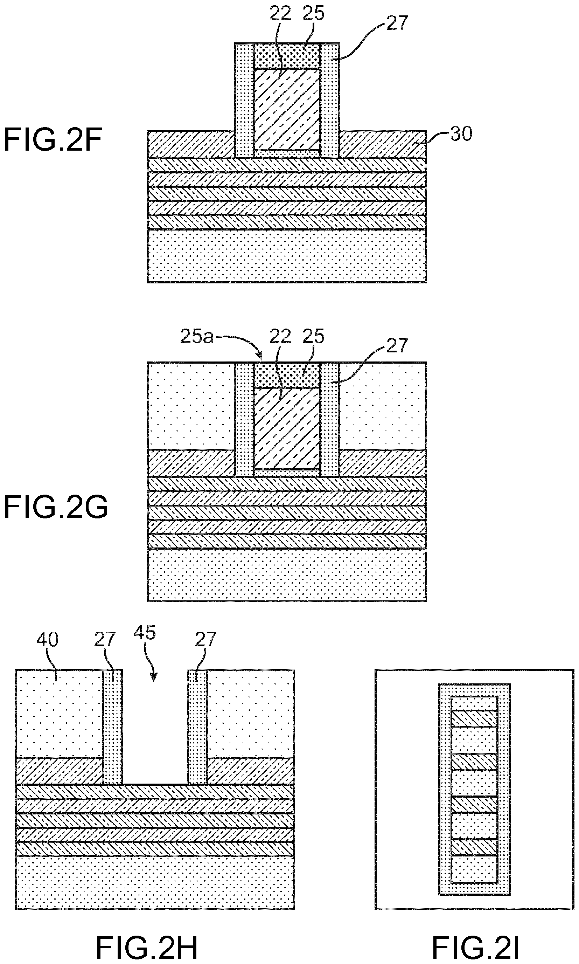

Un exemple de procédé de réalisation d'un transistor formé dans un empilement de couches semi-conductrices superposées va à présent être décrit en liaison avec les figures 2A-2O.

La figure 2A illustre un matériau de départ possible pour cet exemple de procédé sous forme d'un substrat de type semi-conducteur sur isolant, par exemple de type SOI, qui comprend une couche de support semi-conductrice, une couche isolante 11 qui peut être à base d'oxyde de silicium et est disposée sur et en contact de la couche de support 10. La couche isolante 11 du substrat peut être en particulier une couche de type BOX (BOX pour « Burried Oxide ») à base d'un isolant tel que du SiO₂. Une couche de BOX épaisse par exemple de l'ordre de 145 nm peut être prévue.

Le substrat comporte également une couche semi conductrice 12 située sur, et en contact avec la couche isolante 11 du substrat. La couche semi-conductrice 12 superficielle est à base d'un premier matériau semi-conducteur 13 cristallin. Le premier matériau semi-conducteur 13 peut être du Si₁₋ₓGeₓ avec x ≥ 0. Dans cet exemple de réalisation, le premier matériau semi-conducteur 13 peut être du silicium (x=0).

Plusieurs autres couches semi-conductrices sont réalisées sur la couche semi-conductrice 12 superficielle, par exemple par plusieurs épitaxies successives, et forment avec cette dernière un empilement semi-conducteur. L'empilement semi-conducteur peut être formé d'une alternance d'une ou plusieurs couches 12, 12', 12" à base du premier matériau semi-conducteur 13 et d'une ou plusieurs couches 16, 16', à base d'un deuxième matériau semi-conducteur 17 différent dudit premier matériau semi-conducteur. Le deuxième matériau semi-conducteur 17 peut être à base de Si_{1-y}Ge_{y} avec une concentration y en Germanium différente de celle du premier matériau semi-conducteur cristallin 13 et y qui peut être par exemple supérieure à 20%.

On prévoit un empilement d'au moins deux couches semi-conductrices.

Un empilement avec un nombre de 5 couches 12, 16, 12', 16', 12" semi-conductrices est donné à titre d'exemple non limitatif sur la figure 2C.

Les couches 12, 12', 12" à base du premier matériau semi-conducteur 13 peuvent avoir une épaisseur e₁ comprise par exemple entre 5 et 25 nanomètres, par exemple de l'ordre de 12 nm.

Les couches 16, 16', à base du deuxième matériau semi-conducteur 17 peuvent avoir une épaisseur e₂ comprise par exemple entre 5 et 25 nanomètres, par exemple de l'ordre de 12 nm.

Une fois l'empilement réalisé, on grave les couches 12, 12', 12", 16, 16' de ce dernier de manière à réaliser au moins une structure 18 formée d'éléments semi-conducteurs superposés à base du premier matériau semi-conducteur 13 et du deuxième matériau semi-conducteur 17. Les éléments semi-conducteurs peuvent être, suivant leur largeur W par exemple sous forme de nano-fils, ou de barreaux, ou de membranes. La largeur W des éléments semi-conducteurs peut être comprise par exemple entre plusieurs nanomètres et plusieurs dizaines de nm, par exemple de l'ordre de 10 nm. Dans l'exemple de la figure 2C, W est mesurée dans une direction parallèle au plan principal du substrat, le plan principal du substrat, étant un plan passant par le substrat et parallèle au plan [O; x ; y] d'un repère orthogonal [O; x ; y ; z].

Les éléments semi-conducteurs de cette structure 18 peuvent être prévus pour relier un premier bloc et un deuxième bloc destinés à former respectivement une région de source et une région de drain du transistor. Les régions de source et de drain sont dans cet exemple de réalisation des blocs gravés de la structure 18 réalisés en même temps que les éléments semi-conducteurs.

Sur l'exemple de la figure 2C, plusieurs structures 18 juxtaposées formées chacune d'un empilement de nano-fils, ou de barreaux, ou de membranes sont réalisées. La distance D entre deux structures 18 juxtaposées peut être comprise par exemple entre 20 et 50 nanomètres, par exemple de l'ordre de 30 nm. Pour réaliser la ou les structures 18, des techniques de photolithographie et de gravure peuvent être employées.

Ensuite, sur une région centrale des structures 18 de nano-fils, on forme une grille 20 sacrificielle.

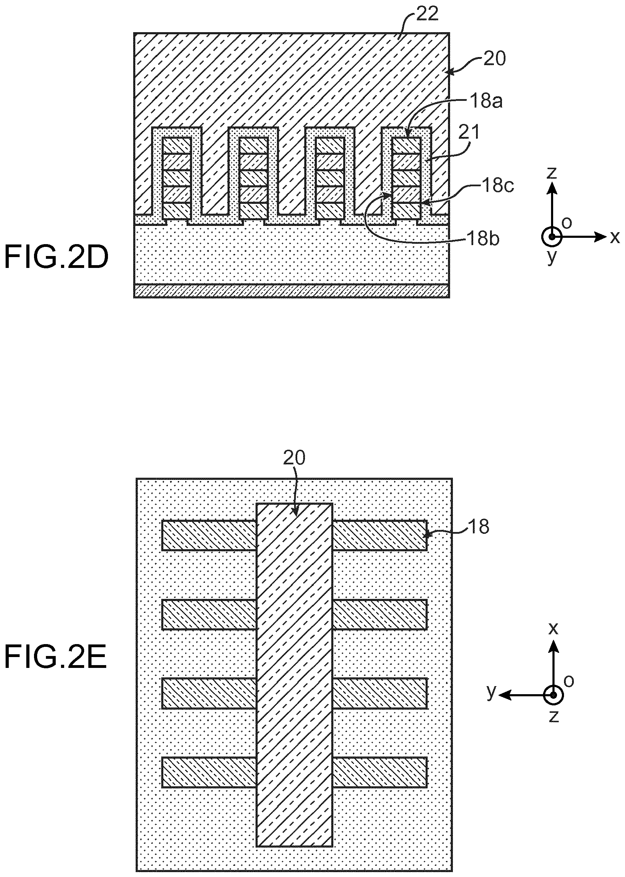

Cette grille sacrificielle 20 recouvre une face supérieure 18a autrement dit le dessus des structures 18 ainsi que des flancs latéraux 18b, 18c de la région centrale des structures 18 (figure 2D).

Pour former cette grille 20 on peut déposer au moins un diélectrique 21 de grille, par exemple à base de SiO₂ que l'on recouvre d'au moins une couche de matériau 22 de grille par exemple tel que du polysilicum. Le diélectrique 21 de grille peut avoir une épaisseur de plusieurs nanomètres, par exemple comprise entre 2 et 6 nm. Le matériau 22 de grille peut quant à lui avoir une épaisseur de plusieurs dizaines de nanomètres, par exemple comprise entre 50 et 200 nm. On effectue ensuite une gravure du diélectrique 21 et du matériau 22 de grille à travers un masquage, qui peut être sous forme d'un masque dur.

Le masque dur peut être par exemple à base de nitrure de silicium et peut avoir une épaisseur comprise entre plusieurs nm et une ou plusieurs dizaines de nm, par exemple de l'ordre de 40 nm.

Sur la figure 2E, la grille sacrificielle 20 recouvrant une région centrale des structures 18 est représentée selon une vue de dessus, sans le masque dur.

On peut former ensuite des espaceurs isolants 27 contre la grille sacrificielle 20 et le masque dur 25. Les espaceurs isolants 27, peuvent être réalisés par dépôt d'une couche isolante, par exemple à base de nitrure de silicium (SiN, SiBCN par exemple, ou SiO₂) jusqu'au niveau du masque dur 25 puis par gravure de cette couche isolante.

Ensuite, on peut former, en particulier par croissance par épitaxie, un matériau semi-conducteur 30 sur les blocs de source et de drain (figure 2F). Le matériau semi-conducteur 30 formé peut être par exemple du silicium carboné SiC:P ou du silicium Si:P, en particulier pour mettre en oeuvre un transistor NMOS. Un dopage du matériau semi-conducteur 30, par exemple au Phosphore (P) peut être en outre effectué. Ce dopage peut être réalisé *in situ* pendant l'épitaxie. Le matériau semi-conducteur 30 recouvre une face supérieure des régions de source et de drain et peut également recouvrir des faces latérales (non montrées sur la vue en coupe transversale de la figure 2F) des régions de source et de drain. Pour mettre en oeuvre un transistor PMOS, du silicium germanium dopé avec du Bore pourrait être utilisé Si₁₋ₓGeₓ:B (avec par exemple x>0,2). Le dopage peut alors également être réalisé *in situ* pendant l'épitaxie.

Puis, on forme une couche de masquage 40 de manière à recouvrir les structures 18 et le masque dur 25. La couche de masquage 40 peut être choisie à base d'un matériau susceptible d'être gravé de manière sélective vis-à-vis de celui du masque dur 25. Cette couche de masquage 40 peut-être par exemple à base d'oxyde de silicium.

Une étape de retrait, par exemple par aplanissement ou polissage CMP (CMP pour « Chemical Mechanical Planarization »), de cette couche de masquage 40 est ensuite réalisée avec un arrêt au niveau du dessus ou de la face supérieure 25a du masque dur 25. La face supérieure 25a du masque dur 25 est ainsi dévoilé(e) à l'issue de cette étape de retrait (figure 2G).

Puis, on réalise dans la couche de masquage 40 en effectuant une ouverture 45 par retrait du masque dur 25 et de la grille sacrificielle 20. L'ouverture 45 peut s'étendre jusqu'à la couche isolante 11 du substrat et dévoiler les faces latérales 18b, 18c des structures 18 au niveau de leur région centrale. L'ouverture 45 peut avoir une section constante et conserver l'empreinte exacte de la grille sacrificielle 20. Le retrait du matériau 22 de la grille sacrificielle 20 peut être réalisé par exemple par une gravure humide à l'aide d'une solution de TMAH (Tétraméthylammonium hydroxide), lorsque le matériau 22 est du polySi. Le diélectrique 21 est ensuite retiré. On obtient ainsi dans l'ouverture 45, une région centrale des structures 18 qui n'est pas recouverte d'un autre matériau (figure 2I sur laquelle le dispositif est représenté selon une vue de dessus).

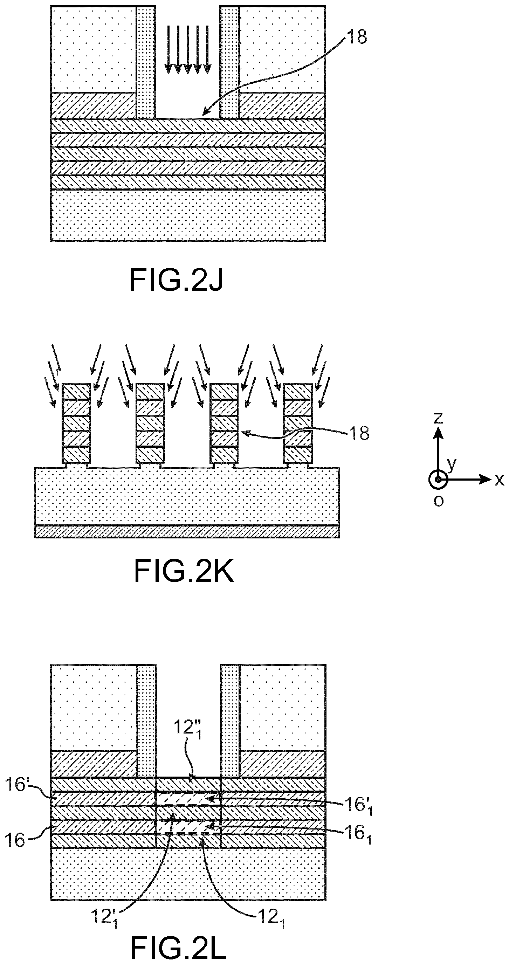

On effectue ensuite une amorphisation d'au moins une zone de la région centrale des structures 18 à l'aide d'une ou plusieurs implantations ioniques (figure 2J et 2K).

Dans cet exemple, on réalise une amorphisation sélective de portions 16₁, 16₁' des couches 16, 16' à base du deuxième matériau semi-conducteur 17 qui sont dévoilées par l'ouverture 45 vis à vis de portions 12₁, 12₁', 12₁" des couches 12, 12', 12" à base du deuxième matériau semi-conducteur 17 qui sont dévoilées par l'ouverture 45.

Les parties 12₁, 12₁', 12₁" ne sont ainsi pas rendues amorphes et conservent leur structure cristalline (figure 2L).

La sélectivité d'amorphisation peut être due au choix des matériaux semi-conducteurs 13 et 17 ainsi que de celui d'un ou plusieurs des paramètres d'implantation(s) que sont la dose, l'énergie et la température d'implantation.

On choisit de préférence le couple de matériaux semi-conducteurs 13 et 17 de sorte que la dose d'implantation requise pour rendre amorphe le deuxième matériau semi-conducteur 17 est plus faible que la dose requise pour rendre amorphe le premier matériau semi-conducteur 13.

Une sélectivité d'amorphisation peut dans cet exemple être obtenue notamment grâce à une différence de concentration en Ge entre le premier matériau semi-conducteur 13 et le deuxième matériau semi-conducteur 17.

Ainsi, pour une même dose donnée d'implantation et une même température donnée, seule la couche 16 à base du deuxième matériau semi-conducteur 17 plus riche en Ge est amorphisée.

Cette sélectivité dans l'amorphisation est par exemple décrite dans le document : « Amorphization threshold in Si implated strained SiGe alloy layers », de T.W. Simpson et al., EMRS 94, Boston.

Pour permettre d'obtenir une bonne sélectivité d'amorphisation, la différence de concentration y-x entre le premier matériau semi-conducteur cristallin 13 et le deuxième matériau semi-conducteur 17 est de préférence supérieure ou égale 15%.

L'homme du métier saura obtenir des courbes expérimentales à différence de concentration en Ge donnée, la dose, l'énergie et la température d'implantation pour obtenir une amorphisation sélective.

A dose et énergie fixées, la température à laquelle le substrat est placé peut être en particulier adaptée afin de modifier la sélectivité d'amorphisation.

Le document de Simpson référencé ci-dessus donne par exemple des fenêtres de température et de dose pour permettre, pour une énergie donnée, d'amorphiser sélectivement du Si_{1-y}Ge_{y} avec y = 0.15 par rapport à du Si ou pour permettre, pour une énergie donnée, d'amorphiser sélectivement du Si_{1-y}Ge_{y} avec y = 0.29 par rapport à du Si.

La figure 6 de ce document montre qu'en se plaçant au-delà d'une première température limite d'implantation donnée par l'abscisse de la courbe « Si » et en deçà d'une deuxième température limite d'implantation donnée par l'abscisse de la courbe « 15% Ge », on peut amorphiser le Si_{1-y}Ge_{y} avec y = 0.15 sans amorphiser le Si.

L'espèce utilisée pour rendre amorphe le deuxième matériau semi-conducteur cristallin 17 peut être par exemple du Si.

L'énergie d'implantation et la dose dépendent de la profondeur à laquelle se situe les portions 16₁, 16'₁ des couches 16, 16' à rendre amorphe.

Afin de pouvoir rendre amorphes des couches 16, 16' situées à différentes hauteurs de la structure 18, une implantation ou plusieurs implantations, réalisées selon des énergies et doses respectives d'implantation différentes peuvent être effectuées.

Dans un mode de réalisation, plusieurs implantations sont réalisées à des énergies respectives d'implantation différentes, chaque énergie étant adaptée de sorte à fournir une concentration maximale de défauts au niveau des portions 16₁, 16'₁ des couches 16, 16' à base du deuxième matériau semi-conducteur 17. L'amorphisation des différentes portions 16₁, 16'₁ de couches à base du deuxième matériau semi-conducteur 17 peut être réalisée selon une séquence d'implantations réalisées à partir de la plus haute à la plus basse énergie. Les doses correspondantes peuvent être adaptées pour les différentes implantations, compte tenu des différentes profondeurs d'implantation, et peuvent tenir compte de l'accumulation de dose fournie par l'implantation séquentielle.

Par exemple, pour rendre amorphe une couche de SiₓGe₁₋ₓ avec x = 0.6, d'épaisseur de l'ordre de 8 nm située à une profondeur de l'ordre de 30 nm d'un empilement semi-conducteur sans rendre amorphe des couches de Si situées respectivement sous et en contact, et sur et en contact de la couche de SiₓGe₁₋ₓ, une implantation de Si à une énergie de 25 keV et une dose de 1.5 x10¹⁴ cm⁻² peuvent être utilisées.

Selon une variante, en adaptant le couple dose énergie d'implantation, on peut réaliser l'amorphisation en une seule implantation ionique. Le document « Selective amophization of ion-bombarded SiGe strained-layer superlattices », de Vos et al., Applied Physics Letter 58(9), 1991 montre par exemple que l'on peut implanter sélectivement des couches de SixGe1-x dans un empilement de couches de Si et de couches de SiₓGe₁₋ₓ.

Dans cet exemple, le fait de conserver la structure cristalline des portions 12₁, 12₁', 12₁" à base du premier matériau semi-conducteur peut permettre notamment d'éviter une recristallisation ultérieure de ces portions 12₁, 12₁', 12₁". Cette recristallisation ultérieure est susceptible éventuellement de générer des défauts dans le matériau semi-conducteur.

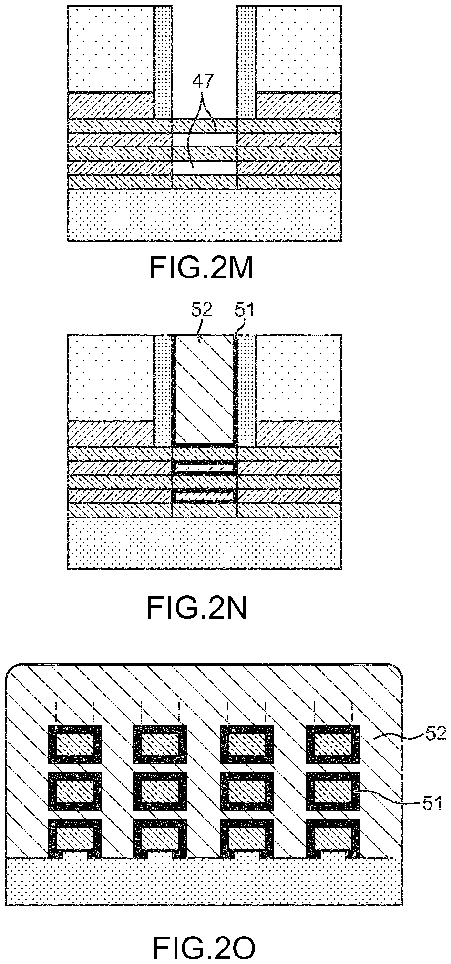

Après l'amorphisation sélective, on effectue un retrait des portions 16₁, 16'₁ des couches 16, 16' à base du deuxième matériau semi-conducteur 17 situées à l'intérieur de l'ouverture 45 (figure 2M).

Ce retrait peut être réalisé par gravure sélective des portions 16₁, 16'₁ à base du deuxième matériau semi-conducteur 17 sous forme amorphe vis-à-vis du reste des couches 16, 16' à base du deuxième matériau semi-conducteur 17 sous forme cristalline et du premier matériau semi-conducteur 13 (figure 2L). On libère ainsi des nano-fils ou des barreaux ou des membranes suspendues à base du premier matériau semi-conducteur.

Une telle gravure sélective peut être réalisée par exemple à l'aide d'une gravure sèche, par exemple à l'aide de HCl, ou de HBr/He/O₂ ou de HBr/Cl₂ ou CF₄/HBr/Cl₂) ou humide, par exemple à l'aide d'une chimie acétique HF/H₂O₂, ou de Hot SC1 (SC1 pour « Standard Clean 1 »), SC1, diluée, le SC1 étant un mélange Eau/Eau oxygénée (H₂O₂)/Ammoniaque (NH₄OH). lorsque le deuxième matériau 17 est à base de silicium germanium et lorsque le premier matériau semi-conducteur 13 est du Si.

On obtient ainsi dans l'ouverture 45, des portions semi-conductrices 12₁, 12₁', 12₁" suspendues à base du premier matériau semi-conducteur. Des espaces vides 47 sont ainsi formés autour de ces portions, en particulier aux endroits où les portions 16₁, 16'₁ ont été retirés. Du fait de la sélectivité de gravure entre les portions 16₁, 16'₁ amorphes des couches 16, 16' et des parties de ces couches situées hors de l'ouverture et dont la forme cristalline a été conservée, on définit de manière précise les espaces vides 47 et on évite une surgravure tel qu'illustrée sur la figure 1.

Ensuite, on forme une grille dans l'ouverture 45 (figures 2N et 2O). La formation de cette grille 50 peut comprendre le dépôt d'un diélectrique 51 de grille tel que par exemple du HfO₂, puis d'au moins un matériau 52 de grille qui peut être métallique, par exemple à base de TiN ou formé d'un empilement de matériau métallique et de matériau semi-conducteur tel que du polysilicium. On remplit ainsi l'ouverture 45 et on forme une grille enrobante 50 comblant les espaces vides autour des portions semi-conductrices 12₁, 12₁', 12₁". La grille 50 réalisée peut être de type GAA (acronyme de « Gate All Around »).

Une étape de retrait du matériau de grille dépassant au-dessus de l'ouverture 45 peut-être ensuite réalisée.

A l'issue de cette étape, une grille auto-alignée dont les dimensions sont définies par celles de l'ouverture 45 est réalisée.

Le transistor que l'on réalise dans cet exemple est ainsi doté d'une structure semi-conductrice de canal formée d'une pluralité d'éléments semi-conducteurs, tels que des nano-fils ou des barreaux ou des membranes, disposés les uns au-dessus des autres et répartis ainsi sur plusieurs niveaux, une grille enrobante étant prévue autour de ces éléments.

Selon un autre exemple de réalisation, un procédé tel que décrit précédemment peut être mis en oeuvre à partir d'un empilement formé d'une alternance d'un premier matériau semi-conducteur 13 à base de Si₁₋ₓGeₓ avec x par exemple tel que 0 ≤ x < 0.1 et d'un deuxième matériau semi-conducteur 17 à base de Si_{1-y}Ge_{y} avec y > x et y supérieure à 0.3, de préférence tel que y-x > 0.15 avantageusement tel que y-x > 0.5.

Une amorphisation sélective par implantation d'une couche de Si_{1-y}Ge_{y} de concentration y en Ge de l'ordre de 30% en utilisant une dose par exemple de l'ordre de 2x10¹⁴ ions/cm² peut être alors réalisée.

Un autre exemple de réalisation adapté en particulier pour mettre en oeuvre un transistor de type PFET peut prévoir comme matériau de départ un substrat de type SiGeOl, dans lequel la couche semi-conductrice 12 superficielle est à base de Si_{1-y}Ge_{y} avec y ≥ 0 et par exemple tel que y = 0,2.

Dans ce cas, l'empilement semi-conducteur que l'on réalise ensuite peut être formé d'une alternance de couches 12, 12', 12" à base de Si_{1-y}Ge_{y} et de couches 16, 16' à base de Si ou de Si₁₋ₓGeₓ avec x>y (x=0,5 et y=0,2 par exemple).

On réalise ensuite les mêmes étapes que dans l'exemple de procédé décrit précédemment. On amorphise en particulier sélectivement des portions des couches 16, 16', tout en conservant la structure cristalline des couches 12, 12', 12". Puis, on grave sélectivement les portions amorphisées des couches 16, 16'. On forme ainsi des nano-fils ou des barreaux ou des membranes suspendues à base de Si_{1-y}Ge_{y}.

Selon une variante de l'exemple de procédé qui vient d'être décrit en liaison avec les figures 2A-2O, on peut, à la place de l'étape d'amorphisation sélective de la région centrale de la ou des structure(s) 18 située(s) dans l'ouverture 45 décrite précédemment en liaison avec les figures 2J-2L, effectuer une amorphisation de l'ensemble de cette région centrale ou avantageusement d'une zone Z de cette région centrale tout en conservant la structure cristalline d'au moins une couche semi-conductrice 12 à base du premier matériau semi-conducteur 13.

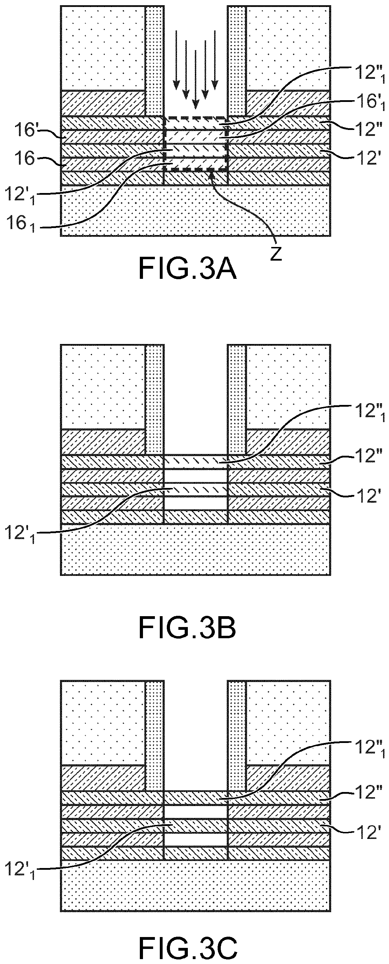

Ainsi dans l'exemple de réalisation de la figure 3A, on réalise une amorphisation de portions 12₁", 12₁', des couches 12", 12', à base du premier matériau semi-conducteur 13 ainsi qu'une amorphisation de portions 16₁', 16₁, des couches 16', 16, à base du deuxième matériau semi-conducteur 17 qui se trouvent dans l'ouverture 45.

Cette amorphisation peut être effectuée à l'aide d'une implantation prévue notamment de par sa dose et son énergie de sorte à conserver la structure cristalline d'une couche 12 base du premier matériau semi-conducteur 13, dans cet exemple de la couche la plus basse de l'empilement semi-conducteur.

On effectue ensuite le retrait sélectif du deuxième matériau rendu amorphe (figure 3B) (gravure HCl, ou HBr/He/O₂ ou HBr/Cl₂ ou CF₄/HBr/Cl₂ ou par chimie acétique HF/H₂O₂, Hot SC1, SC1 diluée).

Un recuit de recristallisation peut être ensuite réalisé. Ce recuit peut être effectué à haute température, par exemple à une température comprise entre 700°C et 1050°C afin de redonner une structure cristalline aux portions 12₁", 12₁', des couches 12", 12'.

Cette recristallisation peut être réalisée par une étape de recuit spécifique (figure 3C) ou peut être effectuée pendant la formation de la grille 50, et en particulier lors d'un recuit visant à stabiliser le diélectrique de grille.

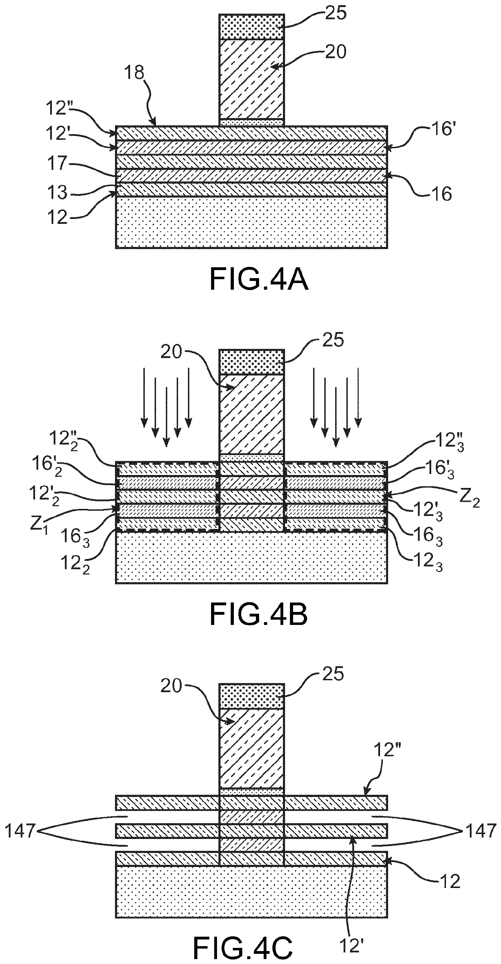

Une autre variante de procédé de réalisation va à présent être décrite en liaison avec les figures 4A-4D.

Pour ce procédé, après avoir réalisé la structure semi-conductrice 18 dans l'empilement formé de l'alternance de couches 12, 12', 12" à base du premier matériau semi-conducteur 13 et de couches 16, 16' à base du deuxième matériau semi-conducteur 17, on réalise une grille sacrificielle sur une région centrale de la structure semi-conductrice 18 (figure 4A).

Cette grille sacrificielle peut être réalisée par exemple d'une manière similaire à la grille sacrificielle 20 décrite précédemment en liaison avec les figures 2D-2E. Ainsi, la formation de la grille sacrificielle 20 peut comprendre une gravure d'une empilement de grille à travers un masque dur 25.

Ensuite, on rend amorphe des zones Z1, Z2 de l'empilement disposées de part et d'autre de la région centrale de la structure 18 sur laquelle repose la grille sacrificielle 20. Dans cet exemple, les zones Z1, Z2 rendues amorphes peuvent contenir des régions de l'empilement dans lesquels les régions de source et de drain du transistor sont prévues. On amorphise ainsi des portions 16₂, 16₃, 16'₂, 16'₃ à base du deuxième matériau semi-conducteur 17 ainsi que des portions 12₂, 12₃, 12'₂, 12'₃, 12"₂, 12"₃ à base du premier matériau semi-conducteur. Une alternative consiste à amorphiser uniquement les portions 16₂, 16₃, 16'₂, 16'₃ à base du deuxième matériau semi-conducteur 17 en laissant cristallines les portions 12₂, 12₃, 12'₂, 12'₃, 12"₂, 12"₃ à base du premier matériau semi-conducteur.

Cette amorphisation peut être réalisée à l'aide d'au moins une (ou plusieurs) implantation ionique (figure 4B). Lors de l'implantation, le masque dur 25 disposé sur la grille peut servir de masque à implantation de sorte à protéger la région centrale de la structure 18. On préserve ainsi la structure cristalline de cette région centrale.

Puis, on retire les portions 16₂, 16₃, 16'₂, 16'₃ des zones Z1, Z2 à base du deuxième matériau semi-conducteur rendues amorphes sélectivement par rapport aux portions 12₂, 12₃, 12'₂, 12'₃, 12"₂, 12"₃ à base du premier matériau semi-conducteur.

Ce retrait peut être réalisé par exemple par gravure du deuxième matériau semi-conducteur 17 sous forme amorphe. Cette gravure est sélective vis-à-vis du deuxième matériau semi-conducteur 17 sous sa forme cristalline et vis-à-vis du premier matériau semi-conducteur 13 sous sa forme cristalline et sous sa forme amorphe.

On définit ainsi des espaces vides 147 entre les couches 12, 12', 12" à base du premier matériau semi-conducteur 13. Du fait de la sélectivité de gravure, ces espaces vides 147 s'étendent de manière précise jusqu'à la région centrale de la structure 18 qui comporte des parties des couches 12, 12', 12", 16, 16' dont la structure cristalline a été conservée (figure 4C).

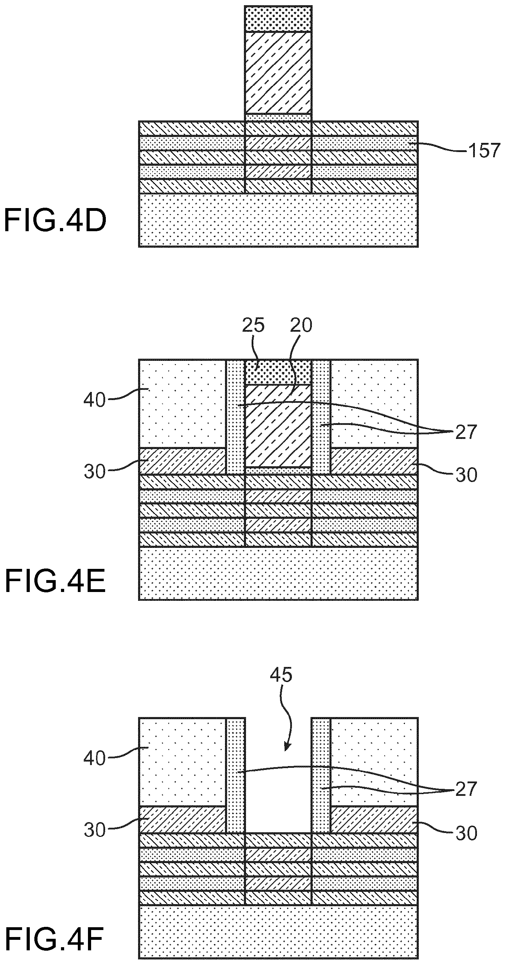

Les espaces vides 147 sont ensuite comblés par un matériau donné 157, qui peut être par exemple un matériau diélectrique (figure 4D). Le matériau donné est un matériau choisi de sorte que l'on puisse graver le deuxième matériau semi-conducteur 17 par rapport à ce matériau donné 157. Le matériau donné 157 peut être par exemple à base de nitrure de silicium (SiₐN_{b}) ou d'oxyde (SiO₂) lorsque le deuxième matériau semi-conducteur est du Si_{1-y}Ge_{y}.

On peut ensuite former les espaceurs isolants 27 contre la grille sacrificielle 20 et le masque dur 25. Puis, on forme le matériau semi-conducteur 30 par croissance par épitaxie sur les blocs de source et de drain. La couche de masquage 40 est ensuite réalisée (figure 4E).

On forme ensuite l'ouverture 45 par retrait du masque dur 25 et de la grille sacrificielle 20 (figure 4F).

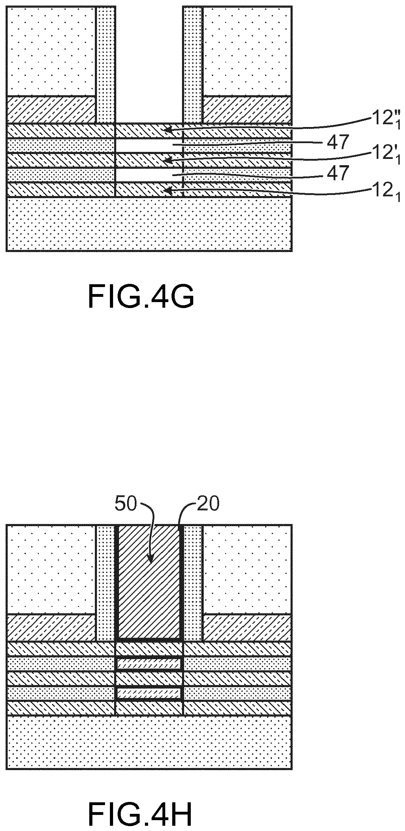

On effectue un retrait de portions 16₁, 16'₁ des couches 16, 16' à base du deuxième matériau semi-conducteur 17 situées à l'intérieur de l'ouverture 45 (figure 4G).

Ce retrait peut être réalisé cette fois par gravure sélective des portions 16₁, 16'₁ à base du deuxième matériau semi-conducteur 17 sous forme cristallline vis-à-vis du matériau donné 157 en contact avec ces portions 16₁, 16'₁ et du premier matériau semi-conducteur 13. On libère ainsi des nano-fils ou des barreaux ou des membranes suspendues à base du premier matériau semi-conducteur 13.

Une telle gravure sélective peut être réalisée par exemple à l'aide d'une gravure sèche (gravure HCl, HBr/He/O₂ ou HBr/Cl₂ ou CF₄/HBr/Cl₂) ou humide (chimie acétique HF/H2O2, Hot SC1, SC1 diluée) lorsque le deuxième matériau 17 que l'on retire dans l'ouverture 45 est à base de silicium germanium et lorsque les matériaux 13 et 157 sont respectivement du Si et du nitrure de silicium (ou de l'oxyde de silicium SiO2). On obtient ainsi dans l'ouverture 45, des portions semi-conductrices 12₁, 12₁', 12₁" à base du premier matériau semi-conducteur 13 dont certaines 12₁', 12₁" sont suspendues.

Un recuit de recristallisation, permettant de redonner une structure cristalline aux portions 12₂, 12₃, 12'₂, 12'₃, 12"₂, 12"₃ à base du premier matériau semi-conducteur peut être ensuite effectué préalablement à la formation d'une grille 50, ou pendant la réalisation de cette grille 50 enrobante dans l'ouverture 45 et venant s'agencer autour des portions semi-conductrices 12₁, 12₁', 12₁" (figure 4H).

Selon une variante de l'un ou l'autre des exemples de procédé qui ont été décrits précédemment en liaison avec les figures 3 et 4, on peut prévoir le transistor dans un empilement formé d'une alternance de matériaux semi-conducteurs différents de ceux donnés dans les exemples précédents.

Un procédé tel que décrit précédemment s'applique particulièrement à la mise en oeuvre de transistors MOSFET à structure de canal formée de nano-fils répartis sur plusieurs niveaux et à grille enrobante. Cette grille peut être formée en particulier après libération des nano-fils (approche dite « gate last »).

Un transistor obtenu à l'aide d'un procédé tel que décrit précédemment peut être inclus par exemple dans un circuit intégré logique à haute performance et faible consommation, ou par exemple dans mémoire, en particulier une mémoire de type Flash NAND, une mémoire moléculaire, ou par exemple dans un capteur tel qu'un détecteur de charge.

## Revendications

1. Procédé de réalisation d'un transistor formé dans un empilement de couches semi-conductrices superposées, le procédé comprenant des étapes consistant à :
a) prévoir sur un substrat, au moins une structure semi-conductrice (18) formée d'un empilement comprenant une alternance de couche(s) (12, 12', 12") à base d'au moins un premier matériau semi-conducteur (13) et de couche(s) (16, 16') à base d'au moins un deuxième matériau semi-conducteur (17) différent du premier matériau semi-conducteur,
b) rendre amorphe à l'aide d'une ou plusieurs implantations, au moins une zone (Z1, Z2, R, R') de la structure (18), la zone rendue amorphe comprenant une ou plusieurs portions (16₁, 16'₁, 16₂, 16'₂, 16₃, 16'₃) d'une ou plusieurs couches à base du deuxième matériau semi-conducteur (17),
c) retirer les portions (16₁, 16'₁, 16₂, 16'₂, 16₃, 16'₃) par gravure sélective du deuxième matériau semi-conducteur (17) rendu amorphe vis-à-vis du premier matériau semi-conducteur (13).

2. Procédé selon la revendication 1, dans lequel la zone rendue (R, R') amorphe à l'étape b) est située dans une région centrale de la structure (18) dans laquelle une région de canal du transistor est apte à être formée,
le procédé comprenant en outre, après l'étape a) et préalablement à l'étape b) :
- formation d'un masquage sur l'empilement, le masquage comprenant une ouverture (45) dévoilant une région centrale de la structure (18),
la ou les implantations à l'étape b) étant réalisées à travers l'ouverture (45) du masquage, de sorte que la zone rendue (R, R') amorphe est située dans l'ouverture (45) tandis que l'on conserve la structure cristalline de parties de la ou des couches à base du deuxième matériau semi-conducteur situées hors de l'ouverture (45),
le retrait des portions étant ensuite effectué à l'étape c) par gravure sélective du deuxième matériau semi-conducteur (17) sous forme amorphe vis-à-vis des couches à base du premier matériau semi-conducteur (13) et des parties de la ou des couches à base du deuxième matériau semi-conducteur (17) dont la structure cristalline a été conservée à l'étape b),
puis après l'étape c), formation d'une grille (50) dans l'ouverture (45).

3. Procédé selon la revendication 2, dans lequel l'amorphisation à l'étape b) est une amorphisation sélective des portions (16₁, 16'₁) à base du deuxième matériau semi-conducteur (17) vis-à-vis des couches (12, 12', 12") à base du premier matériau semi-conducteur (13).

4. Procédé selon la revendication 3, dans lequel le premier matériau semi-conducteur (13) est à base de Si ou de Si₁₋ₓGeₓ (avec x > 0), le deuxième matériau semi-conducteur (17) étant à base de Si_{1-y}Ge_{y} avec 0 ≤ x < y.

5. Procédé selon la revendication 2, dans lequel l'amorphisation à l'étape b) est une amorphisation partielle de la région centrale de la structure (18) de sorte à rendre amorphe une ou plusieurs portions (16₁, 16'₁, 16₂, 16'₂, 16₃, 16'₃) d'une ou plusieurs couches à base du deuxième matériau semi-conducteur (17) et en outre une ou plusieurs couches (12', 12") données à base du premier matériau semi-conducteur (13) tout en conservant la structure cristalline d'au moins une couche (12) à base du premier matériau semi-conducteur (13).

6. Procédé selon la revendication 5, comprenant après retrait des portions à l'étape c), au moins une étape de recuit thermique de sorte à re-cristallier les couches données (12', 12") à base du premier matériau semi-conducteur (13).

7. Procédé selon l'une des revendications 2 à 6, dans lequel le masquage est réalisé préalablement à l'étape b) par formation d'une grille sacrificielle (20) agencée sur la région centrale de la structure, puis formation d'une couche de masquage contre la grille sacrificielle de manière à former le masquage, puis formation de l'ouverture (45) dans le masquage par retrait de la grille sacrificielle.

8. Procédé selon la revendication 1, dans lequel la zone rendue amorphe (Z1, Z2) est située dans des régions de la structure dans lesquelles des régions de source et de drain du transistor sont aptes à être formées, la ou les implantations étant réalisées à l'étape b) de sorte à conserver la structure cristalline d'une région centrale (R) de la structure (18) dans laquelle une région de canal du transistor est apte à être réalisée,
le retrait à l'étape c) des portions étant ensuite effectué par gravure sélective du deuxième matériau semi-conducteur (17) sous forme amorphe vis-à-vis des couches à base du premier matériau semi-conducteur (13) et de parties de la ou des couches à base de deuxième matériau semi-conducteur (17) situées dans la région centrale et dont la structure cristalline a été conservée.

9. Procédé selon la revendication 8, dans lequel le retrait des portions conduit à la formation d'espaces vides (147), le procédé comprenant en outre des étapes de :
- dépôt d'un matériau donné (157) dans les espaces vides (147),
- formation d'un masquage doté d'une ouverture (45) dévoilant la région centrale de la structure,
- retrait de parties (16₁, 16'₁) à base du deuxième matériau semi-conducteur dans l'ouverture par gravure sélective du deuxième matériau semi-conducteur vis-à-vis du premier matériau semi-conducteur et du matériau donné (157).

10. Procédé selon la revendication 9, dans lequel à l'étape b), une grille sacrificielle (20) est agencée en regard de la région centrale, le procédé comprenant en outre la formation d'une couche de masquage contre la grille sacrificielle (20) de manière à former le masquage, l'ouverture (45) étant réalisée par retrait de la grille sacrificielle.

11. Procédé selon l'une des revendications 8 à 10, comprenant en outre après l'étape c) au moins une étape de recuit thermique de sorte à re-cristallier les couches à base du premier matériau semi-conducteur (13).

12. Procédé selon l'une des revendications 1 à 11, dans lequel l'empilement comprenant une alternance de couche(s) (12, 12', 12") à base de Si₁₋ₓGeₓ, et de couches à base de Si_{1-y}Ge_{y} avec 0 ≤ x < y.

13. Procédé selon l'une des revendications 1 à 12, dans lequel l'empilement est formé sur un substrat de type SOI ou SiGeOI.

## Patentansprüche

1. Verfahren zum Herstellen eines Transistors, welcher durch eine Stapelung von überlagerten Halbleiter-Schichten gebildet ist, wobei das Verfahren Schritte umfasst, bestehend aus:
a) Vorsehen wenigstens einer Halbleiter-Struktur (18) auf einem Substrat, welche durch eine Stapelung gebildet ist, umfassend ein Abwechseln von einer oder mehreren Schichten (12, 12', 12") auf Grundlage wenigstens eines ersten Halbleiter-Materials (13) und einer oder mehrerer Schichten (16, 16') auf Grundlage wenigstens eines zweiten Halbleiter-Materials (17), welches von dem ersten Halbleiter-Material verschieden ist,
b) amorph Machen wenigstens einer Zone (Z1, Z2, R, R') der Struktur (18) mit Hilfe einer oder mehrerer Implantationen, wobei die amorph gemachte Zone einen oder mehrere Abschnitte (16₁, 16'₁, 16₂, 16'₂, 16₃, 16'₃) von einer oder mehreren Schichten auf Grundlage des zweiten Halbleiter-Materials (17) umfasst,
c) Entfernen der Abschnitte (16₁, 16'₁, 16₂, 16'₂, 16₃, 16'₃) durch selektives Ätzen des zweiten Halbleiter-Materials (17), welches amorph gemacht ist, gegenüber dem ersten Halbleiter-Material (13).

2. Verfahren nach Anspruch 1, wobei die in Schritt b) amorph gemachte Zone (R, R') in einem zentralen Bereich der Struktur (18) angeordnet ist, in dem ein Kanalbereich des Transistors gebildet werden kann,
wobei das Verfahren ferner nach dem Schritt a) und vor dem Schritt b) umfasst:
- Bilden einer Maske auf der Stapelung, wobei die Maske eine Öffnung (45) umfasst, welche einen zentralen Bereich der Struktur (18) freilegt,
wobei die Implantationen(en) in Schritt b) durch die Öffnung (45) der Maske hindurch derart durchgeführt wird/werden, dass die amorph gemachte Zone (R, R') in der Öffnung (45) angeordnet ist, wohingegen die kristalline Struktur von Teilen der Schicht(en) auf Grundlage des zweiten Halbleiter-Materials, welche außerhalb der Öffnung (45) angeordnet sind, beibehalten wird,
wobei das Entfernen der Abschnitte anschließend in Schritt c) durch selektives Ätzen des zweiten Halbleiter-Materials (17) in amorpher Form gegenüber den Schichten auf Grundlage des ersten Halbleiter-Materials (13) und Abschnitten der Schichten(en) auf Grundlage des zweiten Halbleiter-Materials (17), deren kristalline Struktur in Schritt b) beibehalten worden ist, durchgeführt wird, und nach Schritt c) ein Bilden eines Anschlusses (50) in der Öffnung (45).

3. Verfahren nach Anspruch 2, wobei die Amorphisierung in Schritt b) eine selektive Amorphisierung von Abschnitten (16₁, 16'₁) auf Grundlage des zweiten Halbleiter-Materials (17) gegenüber Schichten (12, 12', 12") auf Grundlage des ersten Halbleiter-Materials (13) ist.

4. Verfahren nach Anspruch 3, wobei das erste Halbleiter-Material (13) auf Grundlage von Si oder Si₁₋ₓGeₓ (mit x>0) ist, wobei das zweite Halbleiter-Material (17) auf Grundlage von Si_{1-y}Ge_{y} mit 0 ≤ x < y ist.

5. Verfahren nach Anspruch 2, wobei die Amorphisierung in Schritt b) eine derartige teilweise Amorphisierung des zentralen Bereichs der Struktur (18) ist, dass ein oder mehrere Abschnitte (16₁, 16'₁, 16₂, 16'₂, 16₃, 16'₃) von einer oder mehreren Schichten auf Grundlage des zweiten Halbleiter-Materials (17) und ferner eine oder mehrere gegebene Schichten (12', 12") auf Grundlage des ersten Halbleiter-Materials (13) amorph gemacht werden, wobei die kristalline Struktur von wenigstens einer Schicht (12) auf Grundlage des ersten Halbleiter-Materials (13) beibehalten wird.

6. Verfahren nach Anspruch 5, umfassend nach dem Entfernen der Abschnitte in Schritt c) wenigstens einen Schritt eines derartigen Temperns, dass die gegebenen Schichten (12', 12") auf Grundlage des ersten Halbleiter-Materials (13) rekristallisiert werden.

7. Verfahren nach einem der Ansprüche 2 bis 6, wobei die Maske vor Schritt b) durch Bilden einer Opferzone (20) hergestellt wird, welche an dem zentralen Bereich der Struktur angebracht ist, und anschließendes Bilden einer Maskenschicht gegen die Opferzone derart, dass die Maske gebildet wird, und durch anschließendes Bilden der Öffnung (45) in der Maske durch Entfernen der Opferzone.

8. Verfahren nach Anspruch 1, wobei die amorph gemachte Zone (Z1, Z2) in Bereichen der Struktur angeordnet ist, in denen die Source- und Drain-Bereiche des Transistors gebildet werden können, wobei die Implantationen(en) in Schritt b) derart durchgeführt wird/werden, dass die kristalline Struktur von einem zentralen Bereich (R) der Struktur (18) beibehalten wird, in der ein Kanalbereich des Transistors hergestellt werden kann,
wobei das Entfernern von Abschnitten in Schritt c) anschließend durch selektives Ätzen des zweiten Halbleiter-Materials (17) in amorpher Form gegenüber Schichten auf Grundlage des ersten Halbleiter-Materials (13) und Abschnitten der Schicht(en) auf Grundlage des zweiten Halbleiter-Materiales (17), welche in dem zentralen Bereich liegen und deren kristalline Struktur beibehalten worden ist, durchgeführt wird.

9. Verfahren nach Anspruch 8, wobei das Entfernen der Abschnitte zu der Bildung von Freiräumen (147) führt, wobei das Verfahren ferner die Schritte umfasst:
- Anlagern eines gegebenen Materials (157) in den Freiräumen (147),
- Bilden einer mit einer Öffnung (45) versehenen Maske, welche den zentralen Bereich der Struktur freilegt,
- Entfernen von Teilen (16₁, 16'₁) auf Grundlage des zweiten Halbleiter-Materials in der Öffnung durch selektives Ätzen des zweiten Halbleiter-Materials gegenüber dem ersten Halbleiter-Material und dem gegebenen Material (157).

10. Verfahren nach Anspruch 9, wobei in Schritt b) eine Opferzone (20) gegenüber dem zentralen Bereich platziert wird, wobei das Verfahren ferner das Bilden einer Maskenschicht gegen die Opferzone (20) derart umfasst, dass die Maske gebildet wird, wobei die Öffnung (45) durch Entfernen der Opferzone hergestellt wird.

11. Verfahren nach einem der Ansprüche 8 bis 10, ferner umfassend nach Schritt c) wenigstens einen Schritt eines derartigen Temperns, dass die Schichten auf Grundlage des ersten Halbleiter-Materials (13) rekristallisiert werden.

12. Verfahren nach einem der Ansprüche 1 bis 11, wobei die Schichtung abwechselnd eine oder mehrere Schichten (12, 12', 12") auf Grundlage von Si₁₋ₓGeₓ und Schichten auf Grundlage von Si_{1-y}Ge_{y} mit 0 ≤ x < y umfasst.

13. Verfahren nach einem der Ansprüche 1 bis 12, wobei die Schichtung auf einem Substrat vom SOI-Typ oder dem SiGeOI-Typ gebildet ist.

## Claims

1. A method for making a transistor formed in a stack of superimposed semi-conductor layers, the method comprising the steps of:
a) providing on a substrate, at least one semi-conductor structure (18) formed by a stack comprising alternating layer(s) (12, 12', 12") based on at least one first semi-conductor material (13) and layer(s) (16, 16') based on at least one second semi-conductor material different from the first semi-conductor material (17),
b) making amorphous, using one or more implantations, at least one zone (Z1, Z2, R, R') of the structure (18), the zone made amorphous comprising one or more portions (16₁, 16'₁, 16₂, 16'₂, 16₃, 16'₃) of one or more layers based on the second semi-conductor material,
c) removing the portions (16₁, 16'₁, 16₂, 16'₂, 16₃, 16'₃) by selectively etching the second semi-conductor material (17) made amorphous towards the first semi-conductor material (13).

2. The method according to claim 1, wherein the zone made (R, R') amorphous in step b) is located in a centre region of the structure (18) in which a channel region of the transistor is able to be formed, the method further comprising, after step a) and prior to step b):
- forming a masking onto the stack, the masking comprising an aperture (45) revealing a centre region of the structure (18),
the implantation(s) in step b) being made through the aperture (45) of the masking, such that the zone made amorphous (R, R') is located in the aperture whereas the crystal structure of parts of the layer(s) based on the second semi-conductor material located outside the aperture (45) is preserved,
the removal of the portions being then performed in step c) by selectively etching the second semi-conductor material (17) in an amorphous form towards the layers based on the first semi-conductor material (13) and the parts of the layer(s) (17) based on the second semi-conductor material, the crystal structure of which has been preserved in step b), and then after step c), forming a gate (50) in the aperture (45).

3. The method according to claim 2, wherein the amorphization in step b) is a selective amorphization of the portions (16₁, 16'₁) based on the second semi-conductor material (17) towards the layers (12, 12', 12") based on the first semi-conductor material (13).

4. The method according to claim 3, wherein the first semi-conductor material (13) is based on Si or Si₁₋ₓGeₓ (with x > 0), the second semi-conductor material (17) being based on Si_{1-y}Ge_{y} with 0 ≤ x < y.

5. The method according to claim 2, wherein the amorphization in step b) is a partial amorphization of the centre region of the structure (18) so as to make amorphous one or more portions (16₁, 16'₁, 16₂, 16'₂, 16₃, 16'₃) of one or more layers based on the second semi-conductor (17) material and further one or more given layers (12', 12") based on the first semi-conductor material (13) while preserving the crystal structure of at least one layer (12) based on the first semi-conductor material (13).

6. The method according to claim 5, comprising after removing the portions in step c), at least one step of thermal annealing so as to recrystallize the given layers based (12', 12") on the first semi-conductor material (13).

7. The method according to any of the claims 2 to 6, wherein the masking is made prior to step b) by forming a sacrificial gate arranged on the centre region of the structure, and then forming a masking layer against the sacrificial gate (20) so as to form the masking, and then forming the aperture (45) in the masking by removing the sacrificial gate.

8. The method according to claim 1, wherein the zone made amorphous (Z1, Z2) is located in regions of the structure in which source and drain regions of the transistor are able to be formed, the implantation(s) being made in step b) so as to preserve the crystal structure of a centre region (R) of the structure (18) in which a channel region of the transistor is able to be made,
the removal in step c) of the portions being then performed by selectively etching the second semi-conductor material (17) in an amorphous form towards the layers based on the first semi-conductor material (13) and parts of the layer(s) based on the second semi-conductor material located in the centre region and the crystal structure of which has been preserved.

9. The method according to claim 8, wherein the removal of the portions results in forming empty spaces (147), the method further comprising steps of:
- depositing a given material (157) in the empty spaces (147),
- forming a masking provided with an aperture (45) revealing the centre region of the structure,
- removing parts based (16₁, 16'₁) on the second semi-conductor material in the aperture by selectively etching the second semi-conductor material towards the first semi-conductor material and the given material (157).

10. The method according to claim 9, wherein in step b), a sacrificial gate (20) is arranged facing the centre region, the method further comprising forming a masking layer against the sacrificial gate (20) so as to form the masking, the aperture (45) being made by removing the sacrificial gate.

11. The method according to any of the claims 8 to 10, further comprising after step c), at least one step of thermal annealing so as to recrystallize the layers based on the first semi-conductor material (13).

12. The method according to any of the claims 1 to 11, wherein the stack comprises alternating layer(s) (12, 12', 12") based on Si₁₋ₓGeₓ, and layers based on Si_{1-y}Ge_{y} with 0 ≤ x < y.

13. The method according to any of the claims 1 to 12, wherein the stack is formed on a SOI or SiGeOI type substrate.
